Europäisches Patentamt

European Patent Office

Office européen des brevets

(19)

(11) EP 0 977 270 A2

(12) EUROPÄISCHE PATENTANMELDUNG

(43) Veröffentlichungstag:
02.02.2000 Patentblatt 2000/05

(51) Int. Cl.⁷: H01L 29/737

(21) Anmeldenummer: 99110029.8

(22) Anmeldetag: 21.05.1999

(84) Benannte Vertragsstaaten:
AT BE CH CY DE DK ES FI FR GB GR IE IT LI LU
MC NL PT SE
Benannte Erstreckungsstaaten:
AL LT LV MK RO SI

(30) Priorität: 29.05.1998 DE 19824111

(71) Anmelder: DaimlerChrysler AG
70567 Stuttgart (DE)

(72) Erfinder:
• Jorke, Helmut
89547 Gerstetten (DE)
• Luy, Johann-Friedrich, Dr.
89073 Ulm (DE)

(54) Resonanz Phasen Transistor mit gegenphasiger Ladungsträgerinjektion

(57) Silizium-Germanium-Heterobipolartransistor mit einem Silizium-Emitter, einer Silizium-Germanium- oder Silizium-Basis und einem Silizium-Kollektor, wobei die Basis einen Injektor enthält, der eine Schichtenfolge aufweist, bei der die Ladungsträgerinjektion durch resonantes Tunneln in die Basis gegenphasig ist. Gegebenenfalls enthält die Basis eine an den Injektor anschließende Driftzone, in der die Basistransitzeit viel kleiner als ein Viertel der Schwingungsperiode ist.

FIG.3

EP 0 977 270 A2

Printed by Xerox (UK) Business Services
2.16.7/3.6

**Beschreibung**

Die Erfindung bezieht sich auf einen bipolaren Transistor nach dem Oberbegriff des Patentanspruchs 1.

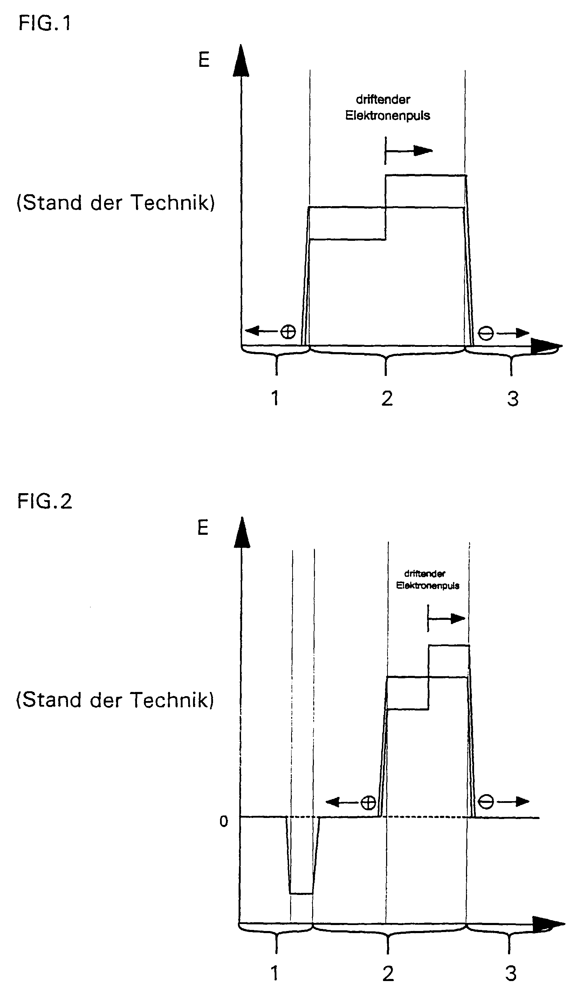

Zur Erzeugung von Hochfrequenzleistung spielen bisher nur Diodenoszillatoren eine maßgebliche Rolle. Dagegen wurden Transistoren aufgrund des verhältnismäßig hohen Basisbahnwiderstands für derartige Oszillatoren als ungeeignet erachtet. (S. Luryi, „Ultrafast operation of heterostructures bipolar transistors resulting from coherent base transport of minority carriers", Proc. ISDRS '93 Charlottesville, 1993, pp. 59). Die Funktionsweise einer pin -Laufzeitdiode als typisches Beispiel eines Diodenoszillators ist in Fig. 1 durch die elektrische Feldverteilung E im p-Emitter 1, i-Driftzone 2 und n-Kollektor 3 schematisch dargestellt. Durch die Flächenladung der driftenden Elektronen wird der Laufraum in ein Gebiet größerer Feldstärke vor den Elektronen und in ein Gebiet kleinerer Feldstärke hinter den Elektronen geteilt. Bei konstantem Emitter-Kollektor-Potential steigen sowohl emitter- als auch kollektorseitig die Feldstärken während der Drift der Elektronen stetig an. Da im Innern von Emitter und Kollektor die Feldstärken verschwinden, bedeutet dieser Anstieg einen Abfluß von Elektronen im n-Gebiet und einen Abfluß von Defektelektronen im p-Gebiet. Dieser Influenzstrom kann während des Drifts der Elektronen im äußeren Stromkreis gemessen werden. Beim Bipolartransistor gelten nach Fig. 2 analoge Betrachtungen, wenn die gewünschte Phasenverschiebung des Kollektorstroms durch die Laufzeit in der Basis-Kollektor-Raumladungszone erzeugt wird. Der Influenzstrom fließt dann im Basis-Kollektor-Stromkreis. Jedoch liegt gerade in diesem Kreis der relativ hohe Basiswiderstand (typischerweise >50Ω), so daß diese Konfiguration für eine Entdämpfung eines äußeren Schwingkreises ungünstig ist.

Bisher sind Silizium-Germanium-Bipolartransistoren aus den Schriften DE 42 41 609, DE 43 01 333 und DE 196 17 030 bekannt, die lediglich eine Basis einheitlicher Dotierungs- und Germaniumkonzentration enthalten oder eine einfache Variation in der Dotierungs- oder Germaniumkonzentration aufweisen, die einen hohen Basiswiderstand verursachen und dadurch den beschriebenen Nachteil aufweisen.

Der Erfindung liegt die Aufgabe zugrunde, eine bipolare Si/SiGe Heterotransistor-Struktur anzugeben, bei der der Influenzstrom im Emitter-Kollektor-Stromkreis fließt und in Phase liegende Anteile des Influenzstroms minimal sind.

Die Erfindung wird durch die Merkmale des Patentanspruchs 1 wiedergegeben. Die weiteren Ansprüche enthalten vorteilhafte Aus- und Weiterbildungen der Erfindung.

Der erfindungsgemäße Silizium-Germanium-Bipolartransistor besitzt, ausgehend vom Emitter, im Bereich der Basis eine Driftzone mit einem vorgeschalteten Injektor, der aus zwei dünnen Barriereschichten und einer zwischen den Barriereschichten angeordneten weiteren Schicht zur Bildung eines Potentialtopfs besteht. Durch quantenmechanisches Tunneln von Ladungsträgern durch diese Doppelbarriere, dem sogenannten resonanten Tunneln wird eine gegenphasige Ladungsträgerinjektion gegebenenfalls in die sich unmittelbar anschließende Driftzone der Basis erreicht. Die Driftzone besitzt eine Schichtdicke, bei der die Basistransitzeit kleiner als ein Viertel der Schwingungsperiode ist.

Ein besonderer Vorteil der Erfindung besteht darin, daß ein besonders hoher negativer Ausgangswiderstand des Transistors durch Vermeidung schädlicher in Phase liegender Anteile im Influenzstrom durch die gegenphasige Injektion erzielt wird. Ein Auseinanderfließen des Elektronenpulses durch Elektronendiffusion in der Basis wird durch im Driftfeld in der Driftzone der Basis vermieden.

Im folgenden wird die Erfindung anhand von vorteilhaften Ausführungsbeispielen unter Bezugnahme auf schematische Zeichnungen in den Figuren näher erläutert. Es zeigen:

Fig. 1   Elektrische Feldverteilung in einer pin-Laufzeitdiode (Stand der Technik),

Fig. 2   Elektrische Feldverteilung in einem Bipolartransistor (Stand der Technik),

Fig. 3   Eine Schichtenfolge des erfindungsgemäßen Silizium-Germanium-Bipolartransistors für Betriebsspannungen um 0.8 V,

Fig. 4   Bandstrukturverlauf im Bereich der Basis,

Fig. 5   Gummel-Plot des erfindungsgemäßen Silizium-Germanium-Bipolartransistors,

Fig. 6   Eine Schichtenfolge des erfindungsgemäßen Silizium-Germanium-Bipolartransistors für Betriebspannungen unter 0.8 V.

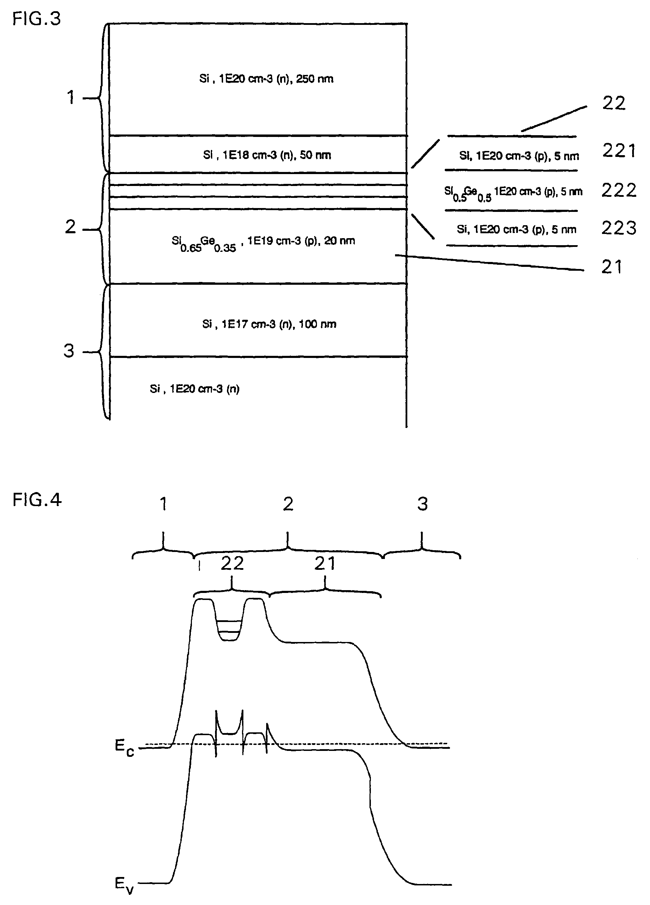

In einem ersten Ausführungsbeispiel wird die Basis 2 gemäß Fig. 3 aus einer Driftzone 21 mit einer Dicke von ca. 20 nm und mit einer Dotierung von ca. $1x10^{19}$ cm$^{-3}$ und einem vorgeschalteten Injektor 22 aufgebaut. Der Injektor 22 bildet eine Doppelbarriere, die aus einer an den Silizium-Emitter 1, bestehend aus einer Dicke von ca. 300 nm, mit einer n-Dotierung in einer Zone von 50 nm auf der Seite der Basis mit einer Konzentration von ca. $1x10^{18}$ cm$^{-3}$ und ca. $1x10^{20}$ cm$^{-3}$ sonst, anschließenden Schichtenfolge mit einer

- ersten Siliziumschicht 221 mit einer Dicke von ca. 5 nm und mit einer p-Dotierung von ca. $1x10^{20}$ cm$^{-3}$,
- Silizium-Germaniumschicht 222 mit einer Dicke von ca. 5 nm und mit einer p-Dotierung von ca. $1x10^{20}$ cm$^{-3}$, und
- zweiten Siliziumschicht 223 mit einer Dicke von ca. 5 nm und mit einer p-Dotierung von ca. $1x10^{20}$ cm$^{-3}$ besteht,

an die eine niedrigerdotierte Driftzone 21 aus Silizium-Germanium anschließt. Die im Injektor 22 liegende Silizium-Germaniumschicht 222 weist gleiche oder niedrigere Dotierkonzentration auf als die umgebenden Siliziumschichten 221 und 222.

Der Kollektor 3 enthält eine n-Dotierung in einer Zone von ca. 100 nm auf der Seite der Basis mit einer Konzentration von ca. $1 \times 10^{17}$ cm$^{-3}$ und im Bereich der darunterliegenden Kollektoranschlußschicht mit ca. $1 \times 10^{20}$ cm$^{-3}$.

Dieser Aufbau führt zur einer sogenannten DBRT-Injektor-Struktur (DBRT...double barrier resonant tunneling), für die der entsprechende Bandstrukturverlauf in Fig. 4 dargestellt ist. Bei hinreichend geringem Abstand der beiden Silizium-Barriere-Schichten bilden sich in dem durch sie definierten Silizium-Germanium-Potentialtopf diskrete Quantenzustände, sogenannte Subbänder aus. Dazu muß in der zwischengeschalteten Silizium-Germanium-Schicht die Kohärenzlänge größer sein als die Weite des Potentialtopfes. Die zugehörige energetische Lage folgt nährungsweise aus der Beziehung

$$E_n = \frac{\pi^2 h^2 n^2}{2mW^2}$$

mit h...Plancksches Wirkungsquantum, n...Ordnung, m...Elektronenmasse, W...Topfbreite

Aufgrund der Verspannung der Silizium-Germanium-Schicht beträgt die effektive Elektronenmasse m = 0.2 $m_0$. Mit W = 5 nm folgt für die erste Ordnung $E_1$ = 50 meV. Dieser Energiewert bezieht sich auf das Leitungsbandminimum im Potentialtopf. Die nächsthöhere Ordnung befindet sich bei $E_2$ = 200 meV. Durch eine Wahl des Germaniumanteils von x = 0.5 beträgt die Barrierenhöhe etwa 370 meV, wodurch keine weiteren Ordnungen mehr auftreten.

Die Höhe der p-Dotierung im Injektor 22 wird durch die Bedingung festgelegt, daß das Ende der Emitter-Basis-Raumladungszone noch innerhalb der ersten Barriere liegt. Diese Bedingung setzt bei einer Barrierenweite von 5 nm eine untere Grenze bei einer Dotierung von etwa p = $2.5 \times 10^{18}$ cm$^{-3}$.

Durch Anlegen einer Spannung zwischen Emitter 1 und Basis 2 in Flußrichtung wird bei einem bestimmten Spannungswert das Quasi-Ferminiveau des Emitters energetisch gleich dem tiefsten Subband des Injektors 22. Dieser Spannungswert liegt bei etwa 0.8 V. Bei dieser Spannung können Elektronen aus dem Injektor 22 aus dem Emitter 1 in die Basis 2 tunneln.

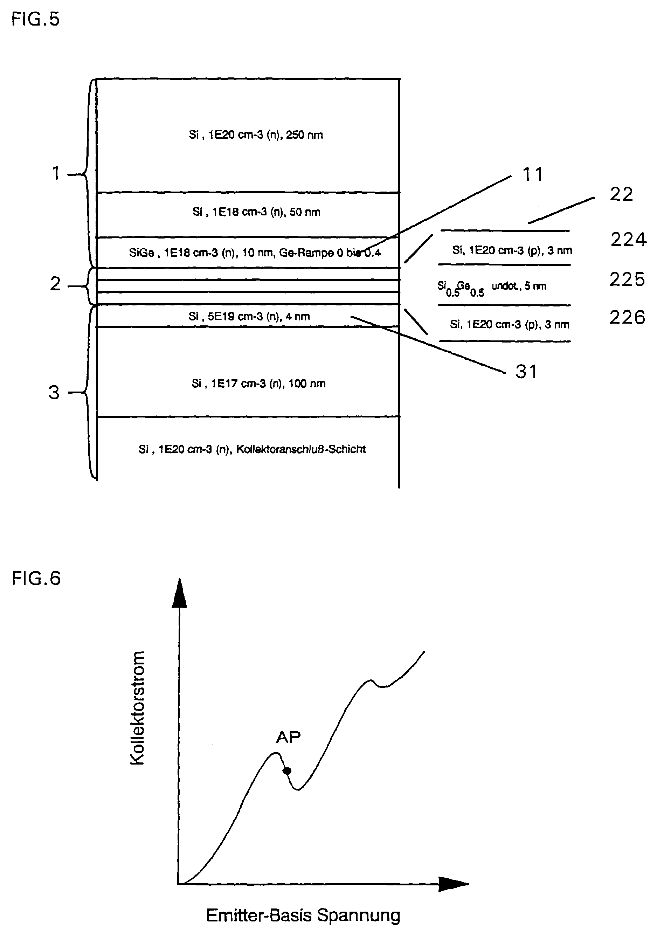

In einem weiteren Ausführungsbeispiel gemäß Fig. 5 besitzt der Kollektor 3 auf der Seite der Basis eine hoch n-dotierte Zone 31 einer Dicke von etwa 4 nm und mit einer Dotierkonzentration von etwa n = $5 \times 10^{19}$ cm$^{-3}$. Die Basis 2 besteht dann lediglich aus dem Injektor 22 mit der Schichtfolge aus einer

- ersten Siliziumschicht 224 mit einer Dicke von ca. 3 nm und mit einer p-Dotierung von ca. $1 \times 10^{20}$ cm$^{-3}$,
- undotierten Silizium-Germaniumschicht 225 mit einer Dicke von ca. 5 nm, und
- zweiten Siliziumschicht 226 mit einer Dicke von ca. 3 nm und mit einer p-Dotierung von ca. $1 \times 10^{20}$ cm$^{-3}$.

Zur Optimierung des Bandstrukturverlaufs im Bereich des Injektors eignet sich zusätzlich im Emitter 1 aufder Seite der Basis eine etwa 10 nm dicke n-dotierte Si-Ge-Schicht 11 mit einem zur Basis 1 ansteigenden rampenförmigen Germaniumgehalt von 0 bis 40%, die eine Dotierkonzentration von etwa n = $1 \times 10^{18}$ cm$^{-3}$ besitzt.

Der mit diesem Prozeß verbundene Gummel-Plot (Strom-Spannungs-Charakteristik) ist in Fig. 6 qualitativ dargestellt. Befinden sich im Potentialtopf mehrere Subbänder, so werden in der Strom-Spannungs-Charakteristik mehrere Maxima durchlaufen.

Wird der Transistor in einen Arbeitspunkt mit negativ differentiellen Widerstand gebracht ( z.B. Punkt AP in Fig. 6), dann werden Elektronen gegenphasig zu einem am Emitter-Basis Eingang anliegenden Hochfrequenzsignal in den Laufraum der Basis injiziert. Sofern dabei ihre Transitzeit kleiner als ein Viertel der Schwingungsperiode ist, wird im Emitter-Kollektor Kreis ein zum Eingangssignal rein gegenphasiger Influenzstrom erzeugt. Für Frequenzen des V-Bandes ( 50-70 GHz ) beträgt die maximal zulässige Transitzeit etwa 4 ps.

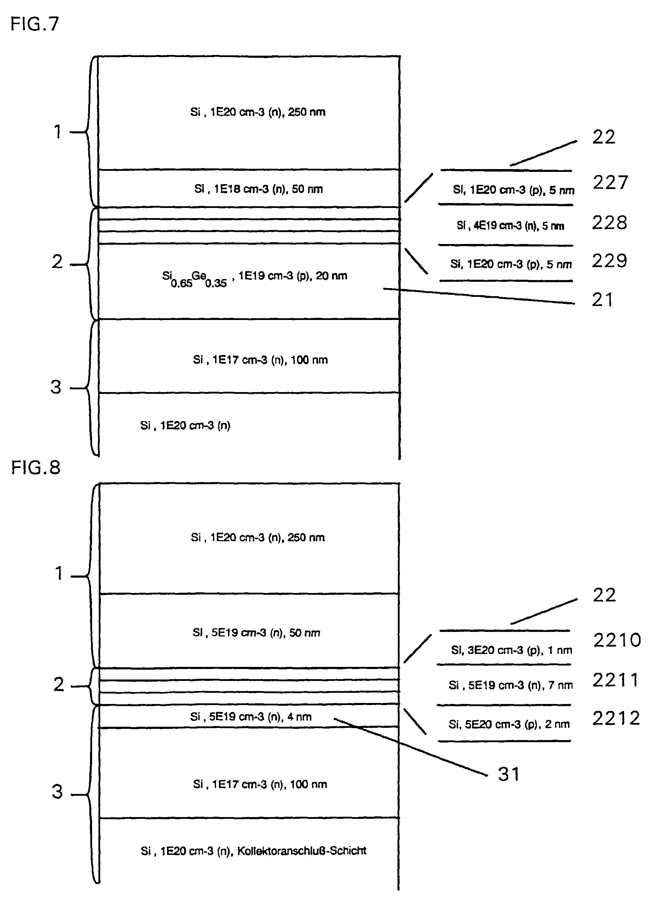

Im weiteren Ausführungsbeispiel gemäß Fig. 7 wird die Tiefe des Potentialtopfes der Barrierenstruktur im Injektor 22 so ausgelegt, daß auch kleinere Spannungswerte unter 0.8 V zum Betrieb möglich sind. Der Schichtaufbau des Injektors 22 bildet einen Potentialtopf, der aus einer an den Silizium-Emitter 1 anschließenden Schichtenfolge mit einer

- ersten Siliziumschicht 227 mit einer Dicke von ca. 5 nm und mit einer p-Dotierung von ca. $1 \times 10^{20}$ cm$^{-3}$,
- Siliziumschicht 228 mit gegensätzlicher Dotierung mit einer Dicke von ca. 5 nm und mit einer n-Dotierung von ca. $4 \times 10^{19}$ cm$^{-3}$ und
- zweiten Siliziumschicht 229 mit einer Dicke von ca. 5 nm und mit einer p-Dotierung von ca. $1 \times 10^{20}$ cm$^{-3}$ besteht,

an die eine niedrigerdotierte Driftzone 21 aus Silizium-Germanium anschließt.

Im weiteren Ausführungsbeispiel gemäß Fig. 8 besitzt zur Optimierung des Bandstrukturverlaufs der Kollektor 3 auf der Seite der Basis 2 eine hoch ndotierte Zone 31 einer Dicke von etwa 4 nm und mit einer Dotierkonzentration von etwa n = $5 \times 10^{19}$ cm$^{-3}$.

Die Basis 2 besteht dann lediglich aus dem Injektor 22 einer Schichtenfolge mit einer

- ersten Siliziumschicht 2210 mit einer Dicke von ca. 1 nm und mit einer p-Dotierung von ca. $3 \times 10^{20}$ cm$^{-3}$,

- Siliziumschicht 2211 mit gegensätzlicher Dotierung mit einer Dicke von ca. 7 nm und mit einer n-Dotierung von ca. $5x10^{19}$ cm$^{-3}$ und
- zweiten Siliziumschicht 2212 mit einer Dicke von ca. 2 nm und mit einer p-Dotierung von ca. $5x10^{20}$ cm$^{-3}$.

In den zwei vorhergehenden Beispielen besteht der Injektor 22 aus Silizium, wobei sich die erforderliche Modulation des Leitungsbandes durch den Einbau einer geeigneten n-Dotierung ergibt. Mit der angegebenen Schichtstruktur sind Potentialbarrieren bis zur Höhe der Bandlücke von etwa 1.1 eV möglich. Der Driftbereich der Basis ist hinsichtlich der p-Dotierung und dem Germanium-Gehalt so konfiguriert, daß sein Leitungsbandminimum energetisch unterhalb jenes Subbandes liegt, das für die gegenphasige Injektion durch resonantes Tunneln genutzt wird.

## Patentansprüche

1. Silizium-Germanium-Heterobipolartransistor mit einem Silizium-Emitter (1), einer Silizium-Germanium-Basis (2) und einem Silizium-Kollektor (3), dadurch gekennzeichnet, daß die Basis einen Injektor (22) enthält, der eine Schichtenfolge aufweist, bei der die Ladungsträgerinjektion durch resonantes Tunneln in die Basis gegenphasig ist.

2. Silizium-Germanium-Heterobipolartransistor nach Anspruch 1, dadurch gekennzeichnet, daß die Basis eine an den Injektor (22) anschließende Driftzone (21) enthält, in der die Basistransitzeit viel kleiner als ein Viertel der Schwingungsperiode ist.

3. Silizium-Germanium-Heterobipolartransistor nach Anspruch 2, dadurch gekennzeichnet, daß der Injektor (22) der Basis (2) einen Potentialtopf bildet, der aus einer an den Silizium-Emitter (1) anschließenden Schichtenfolge mit einer

   - ersten p-Siliziumschicht (221),
   - Silizium-Germaniumschicht (222) und
   - zweiten Siliziumschicht (223) besteht,
     an die eine niedrigerdotierte Drifizone (21) aus Silizium-Germanium anschließt.

4. Silizium-Germarnum-Heterobipolartransistor nach Anspruch 3, dadurch gekennzeichnet, daß die im Injektor (22) liegende Silizium-Germaniumschicht (222) eine gleiche oder niedrigere Dotierkonzentration aufweist als die umgebenden Siliziumschichten (221, 223).

5. Silizium-Germanium-Heterobilolartransistor nach Anspruch 2, dadurch gekennzeichnet, daß der Injektor (22) der Basis (2) einen Potentialtopf bildet, der aus einer an den Silizium-Emitter (1) anschließenden Schichtenfolge einer

   - ersten p-Siliziumschicht (227),
   - Siliziumschicht (228) mit gegensätzlicher n-Dotierung und
   - zweiten p-Siliziumschicht (229) besteht,
     an die eine niedrigerdotierte Driftzone (21) aus Silizium-Germanium anschließt.

6. Silizium-Germanium-Heterobipolartransistor nach Anspruch 1, dadurch gekennzeichnet, daß der Kollektor (3) auf der Seite der Basis (2) eine hochdotierte Zone (31) besitzt.

7. Silizium-Germanium-Heterobipolartransistor nach Anspruch 1 oder 6, dadurch gekennzeichnet, daß der Emitter (1) aufder Seite der Basis (2) eine Silizium-Germanium-Zone (11) mit einem zur Basis zunehmenden Germanium-Gehalt aufweist

8. Silizium-Germamum-Heterobipolartransistor nach Anspruch 1, 6 und 7, dadurch gekennzeichnet, daß der Injektor (22) der Basis (2) einen Potentialtopf bildet, der aus einer an den Silizium-Emitter (1) anschließenden Schichtenfolge einer

   - ersten p-Siliziumschicht (2210),
   - Siliziumschicht (2211) mit gegensätzlicher n-Dotierung und
   - zweiten p-Siliziumschicht (2212) besteht, und die Dotierungskonzentration der ersten Siliziumschicht (2210) kleiner als die Dotierung der zweiten Siliziumschicht (2212) ist.

FIG.1

(Stand der Technik)

E

driftender
Elektronenpuls

⊕

⊖

1    2    3

FIG.2

(Stand der Technik)

E

driftender
Elektronenpuis

0

⊕

⊖

1    2    3

FIG.3

1

Si , 1E20 cm-3 (n), 250 nm

Si , 1E18 cm-3 (n), 50 nm

22

Si, 1E20 cm-3 (p), 5 nm  221

Si$_{0.5}$Ge$_{0.5}$ 1E20 cm-3 (p), 5 nm  222

Si, 1E20 cm-3 (p), 5 nm  223

2

Si$_{0.65}$Ge$_{0.35}$ , 1E19 cm-3 (p), 20 nm

21

3

Si , 1E17 cm-3 (n), 100 nm

Si , 1E20 cm-3 (n)

FIG.4

1        2        3

22        21

$E_c$

$E_v$

FIG.5

Si , 1E20 cm-3 (n), 250 nm

1

Si , 1E18 cm-3 (n), 50 nm

SiGe , 1E18 cm-3 (n), 10 nm, Ge-Rampe 0 bis 0.4

2

Si , 5E19 cm-3 (n), 4 nm

3

Si , 1E17 cm-3 (n), 100 nm

Si , 1E20 cm-3 (n), Kollektoranschluß-Schicht

11

22

Si, 1E20 cm-3 (p), 3 nm — 224

$Si_{0.5}Ge_{0.5}$ undot., 5 nm — 225

Si, 1E20 cm-3 (p), 3 nm — 226

31

FIG.6

Kollektorstrom

AP

Emitter-Basis Spannung

FIG.7

Si , 1E20 cm-3 (n), 250 nm

1

22

Si , 1E18 cm-3 (n), 50 nm

Si, 1E20 cm-3 (p), 5 nm    227

Si , 4E19 cm-3 (n), 5 nm    228

2

Si, 1E20 cm-3 (p), 5 nm    229

$Si_{0.65}Ge_{0.35}$ , 1E19 cm-3 (p), 20 nm

21

Si , 1E17 cm-3 (n), 100 nm

3

Si , 1E20 cm-3 (n)

FIG.8

Si , 1E20 cm-3 (n), 250 nm

1

22

Si , 5E19 cm-3 (n), 50 nm

Si, 3E20 cm-3 (p), 1 nm    2210

Si , 5E19 cm-3 (n), 7 nm    2211

2

Si , 5E19 cm-3 (n), 4 nm

Si, 5E20 cm-3 (p), 2 nm    2212

31

3

Si , 1E17 cm-3 (n), 100 nm

Si , 1E20 cm-3 (n), Kollektoranschluß-Schicht